# EUROPEAN PATENT SPECIFICATION

(11) **EP 2 458 953 B1**
(45) Date of publication and mention of the grant of the patent: **06.03.2013**
(21) Application number: 11189377.2
(22) Date of filing: 16.11.2011
(51) Int. Cl.: H05K 9/00, H05K 3/36, H05K 1/14

(54) **Electronic device**
Elektronische Vorrichtung
Dispositif électronique

(30) Priority: 25.11.2010 JP 2010262414
(43) Date of publication of application: 30.05.2012
(73) Proprietor: Alps Electric Co., Ltd., Tokyo 145-8501 (JP)
(72) Inventor: Sugimori, Yoshio, Tokyo, Tokyo 145-8501 (JP)
(74) Representative: Klunker . Schmitt-Nilson . Hirsch

(56) References cited:
- EP-A2- 1 737 287
- GB-A- 2 319 898
- US-A1- 2003 107 876

## Description

The present invention relates to an electronic device attached upright to a set board.

This type of electronic device, for example, a television or radio tuner has a wiring board on which a wiring pattern and electronic components are mounted. This wiring board is supported by a frame made of metal.

The wiring board is provided with a group of terminals. One end of each terminal is connected to the wiring pattern, and the other end of each terminal protrudes and extends from the edge of the wiring board.

The frame is provided with attaching legs protruding from the edge thereof. By inserting the group of terminals and the attaching legs into a set board, the wiring board and the frame are connected to the set board.

A structure that shields an electronic device is disclosed (see, for example, Japanese Unexamined Patent Application Publication No. 2006-135204).

Specifically, a frame is covered with a lid made of metal, and the inside of an electronic device is shielded from the outside. In this electronic device, the terminals are arranged in a line in the length direction of the electronic device, and the attaching legs are placed at both ends of the group of terminals. The terminals and the attaching legs extend from the bottom plate of the frame (surrounding the lower portion of the wiring board) toward the set board. The electronic device is attached upright to the set board, and the height of the electronic device is larger than the width thereof.

In the case of the above conventional art, the size of the electronic device cannot be reduced. The reason is that the terminals protrude from openings formed in the bottom plate of the frame, there are portions of the bottom plate between the openings, and the size of the electronic device in the length direction cannot be reduced.

To solve this problem, it is possible to remove the portions of the bottom plate between the openings and to arrange the terminals densely.

In other words, the bottom plate can be shaped so as to avoid the terminals. If not only the portions of the bottom plate between the openings but also the portion of the bottom plate between the leftmost opening and the left end of the bottom plate and the portion of the bottom plate between the rightmost opening and the right end of the bottom plate are removed, the size of the electronic device in the length direction can be further reduced.

In this case, the bottom plate is connected only to the lower edge of the front plate (facing the front surface of the wiring board) of the frame and is not connected to the left side plate (surrounding the left portion of the wiring board) of the frame and the right side plate (surrounding the right portion of the wiring board) of the frame. Therefore, there is fear that the bottom plate could be deformed.

Specifically, if a lid simply covers the outside of the frame, the outer surface of the bottom plate is supported from below, and the bottom plate is prone to be bent inward from its proper position and deformed.

If the bottom plate is deformed, the shielding performance decreases. With the deformation of the bottom plate, misalignment of the lid with respect to the frame occurs, the frame and the lid are in contact with each other not in their proper contact position but in an improper position, and noise is generated.

As described above, when reducing the size of an upright electronic device, attention needs to be paid to the prevention of the deformation of the bottom plate of the frame.

Relevant background art is disclosed in documents GB 2 319 898, US 2003/107876 and EP 1 737 827.

The present invention solves the above problem and provides a small-sized electronic device in which the decrease in shielding performance and the generation of noise can be prevented.

In an aspect of the present invention, an electronic device attached upright to a set board includes a wiring board having a board surface that is rectangular in the front view and on which a wiring pattern and electronic components are provided, a group of terminals arranged in a line in the lower portion of the wiring board and connecting the wiring board and the set board, a metal frame supporting the wiring board and used for the attachment to the set board, and a metal lid covering the frame.

The frame includes a front plate facing the board surface and having a lower opening formed in the lower portion thereof and an engaging portion cut and bent inward when the lower opening is formed, a left side plate and a right side plate contiguous with the left edge and the right edge of the front plate and surrounding the left portion and the right portion of the wiring board, a top plate contiguous with the upper edge of the front plate and having a top plate upper surface connected to the left side plate and the right side plate and surrounding the upper portion of the wiring board, and a bottom plate that is located on the opposite side from the top plate with the engaging portion therebetween, that is contiguous with the lower edge of the front plate, that is not connected to the left side plate and the right side plate, that avoids the group of terminals, and that surrounds the lower portion of the wiring board.

The lid includes a front lid covering the front plate, a first upper arm contiguous with the front lid and holding the top plate upper surface from above, and a holding arm contiguous with the front lid, inserted into the lower opening, and supporting the engaging portion from below.

According to the first aspect of the present invention, the electronic device includes a wiring board, a group of terminals, a frame, and a lid and is constructed not in a prone position but in an upright position.

Specifically, when the direction in which the group of terminals are arranged, in other words, the left-right direction of the frame is referred to as the length direction of the device, the thickness direction of the wiring board is referred to as the width direction of the device, and the direction in which the terminals extend, in other words, the top-bottom direction of the frame is referred to as the height direction of the device, the device is constructed such that the size in the height direction of the device is larger than the size in the width direction of the device.

The wiring board is supported by the frame made of metal. The frame is covered by the lid made of metal. Thus, the inside of the device can be shielded from the outside.

The bottom plate of the frame avoids the group of terminals extending toward the set board. The group of terminals can be placed densely along the length direction of the device. Thus, the size in the length direction of the device can be reduced.

In the case where the bottom plate is not connected to the left side plate and the right side plate and is contiguous only with the lower edge of the front plate, there is fear that the bottom plate could be deformed. Specifically, if the lid holds the top plate upper surface from above, supports the lower surface of the bottom plate from below, and covers the frame, the bottom plate contiguous only with the lower edge of the front plate is prone to be bent inward from its proper position.

However, according to the present invention, the front plate of the frame is provided with a lower opening and an engaging portion, and the holding arm of the lid supports the engaging portion which is separate from the bottom plate.

If the lid does not support the lower surface of the bottom plate from below but supports the lower surface of the engaging portion provided in the front plate from below when the lid covers the frame in the top-bottom direction of the lid, the bottom plate can maintain its proper position, and the decrease in shielding performance can be prevented. In addition, the misalignment of the lid with respect to the frame is avoided, and the frame and the lid are in contact with each other at their proper contact position, and therefore noise generation can be prevented. As a result, the reliability of the electronic device improves.

In a second aspect of the present invention, in addition to the configuration of the first aspect of the present invention, the lower opening is formed on the lower edge of the front plate.

According to the second aspect of the present invention, if in addition to the operation of the first aspect of the present invention, the lower opening is formed on the border between the front plate and the bottom plate, the bottom plate can be bent to its proper position easily. In addition, because the lower opening also has a function to provide the engaging portion, the need to separately form the opening for facilitating bending and the opening for providing the engaging portion is eliminated, and the decrease in shielding performance can be further prevented.

In a third aspect of the present invention, in addition to the configuration of the first or second aspect of the present invention, the front plate has an upper opening in the upper portion thereof, and the lid has a second upper arm that is inserted into the upper opening and supports a top plate lower surface facing the edge of the wiring board from below.

According to the third aspect of the present invention, in addition to the operation of the first or second aspect of the present invention, the lid covers the top plate of the frame with a clip structure. Specifically, the first upper arm holds the top plate upper surface from above, and the second upper arm supports the top plate lower surface from below. The top plate is pinched between the first upper arm and the second upper arm. Therefore, the lid is less prone to come off of the frame.

In a fourth aspect of the present invention, in addition to the configuration of the third aspect of the present invention, the upper opening is formed on the upper edge of the front plate.

According to the fourth aspect of the present invention, if in addition to the operation of the third aspect of the present invention, the upper opening is formed on the border between the front plate and the top plate, the top plate can be bent easily. In addition, because the upper opening also has a function to receive the second upper arm, the need to separately form the opening for facilitating bending and the opening for inserting the second upper arm is eliminated, and the decrease in shielding performance can be further prevented.

In a fifth aspect of the present invention, in addition to the configuration of any one of the first to fourth aspects of the present invention, the top plate upper surface has an outer protrusion protruding outward in the vicinity of the upper edge of the front plate, and the first upper arm engages with the outer protrusion and holds the top plate upper surface from above.

According to the fifth aspect of the present invention, if in addition to the operation of any one of the first to fourth aspects of the present invention, the first upper arm engages with the outer protrusion, the position of the lid relative to the frame is defined, and the frame and the lid can be in contact with each other at their proper contact position firmly.

According to the present invention, the lid does not support the bottom plate of the frame from below but supports the front plate of the frame from below. Therefore, an electronic device in which even if the bottom plate avoids the terminals, the bottom plate does not deform can be provided.

### BRIEF DESCRIPTION OF THE DRAWINGS

Fig. 1 is a front view of a tuner of the embodiment attached to a mother board;
Fig. 2 is a perspective view of the exterior of the tuner of Fig. 1;
Fig. 3 is a front view of the tuner of Fig. 2;
Fig. 4 is a back view of the tuner of Fig. 2;
Fig. 5 is a perspective view of the frame of Fig. 2;
Fig. 6 is a perspective view of the frame of Fig. 5;
Fig. 7 is a side view of the frame of Fig. 5;
Fig. 8 is a perspective view of the front cover of Fig. 2;
Fig. 9 is a perspective view of the exterior of the tuner of Fig. 1;
Fig. 10 is a side view of the tuner of Fig. 9; and
Fig. 11 is a side view of the tuner of Fig. 9.

A preferred embodiment of the present invention will now be described with reference to the drawings.

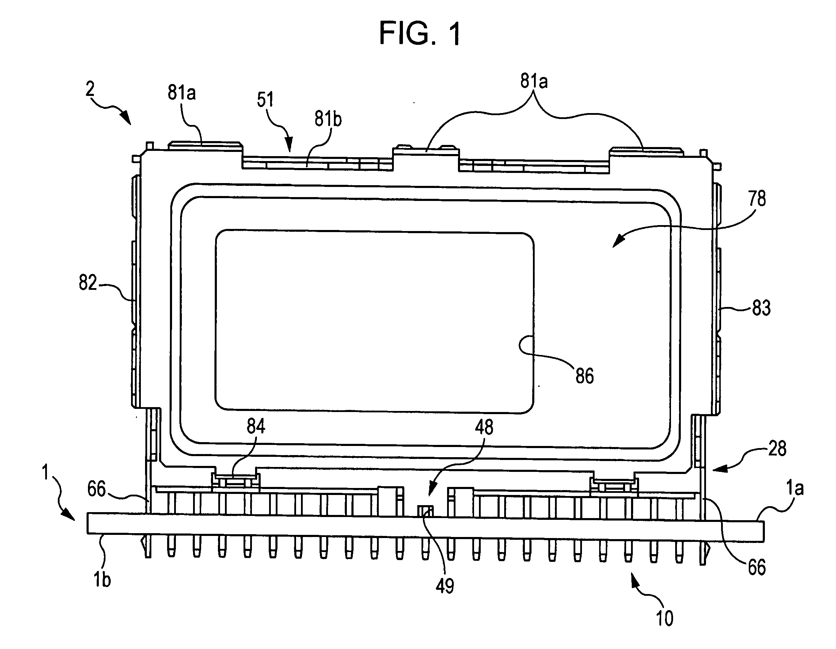

Fig. 1 is a front view of the exterior of an FM/AM tuner (electronic device) 2 according to this embodiment. The tuner 2 is housed together with a mother board (set board) 1, for example, in a case of a car stereo.

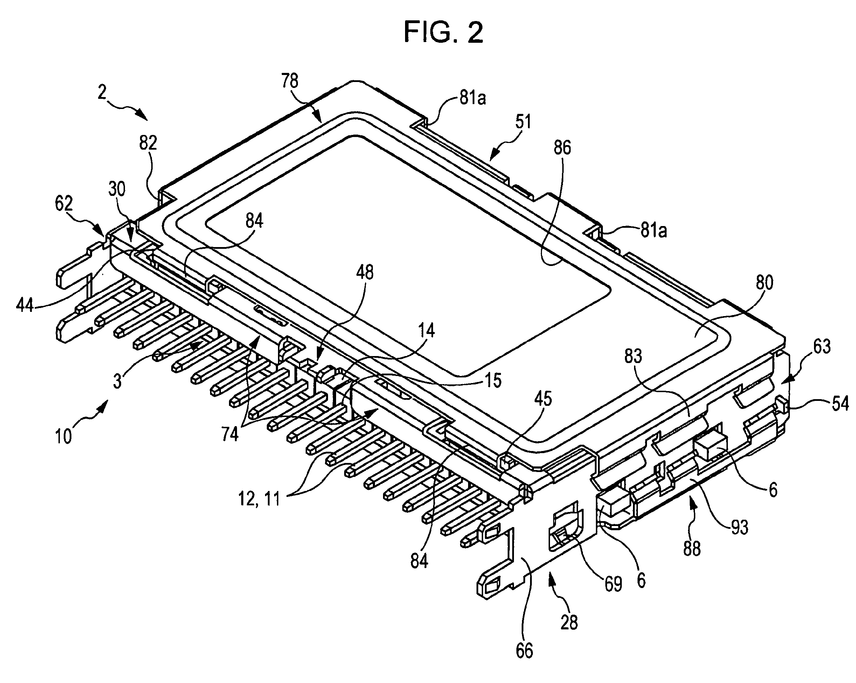

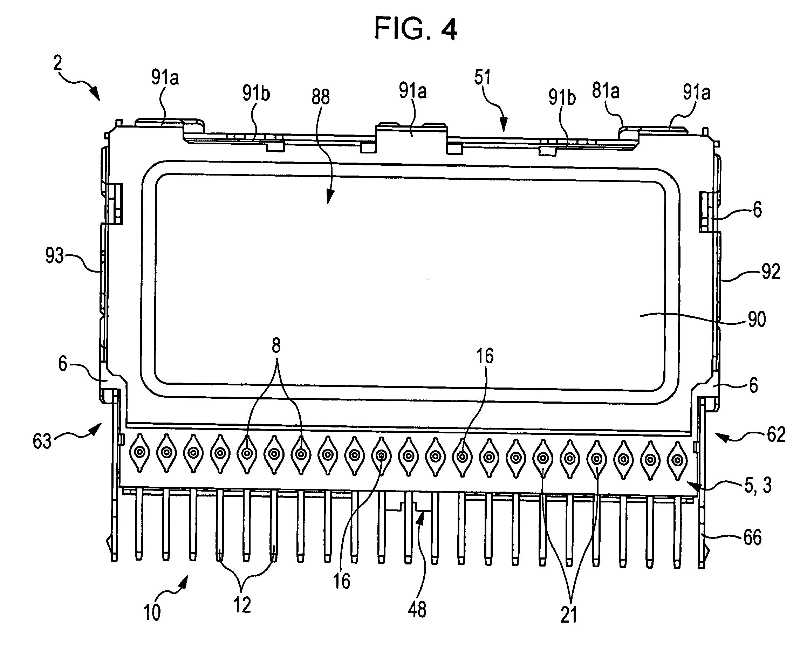

The front of the tuner 2 is covered by a front cover (lid) 78 made of metal (Figs. 1 to 3), and the back of the tuner 2 is covered by a back cover (lid) 88 made of metal (Figs. 2 and 4).

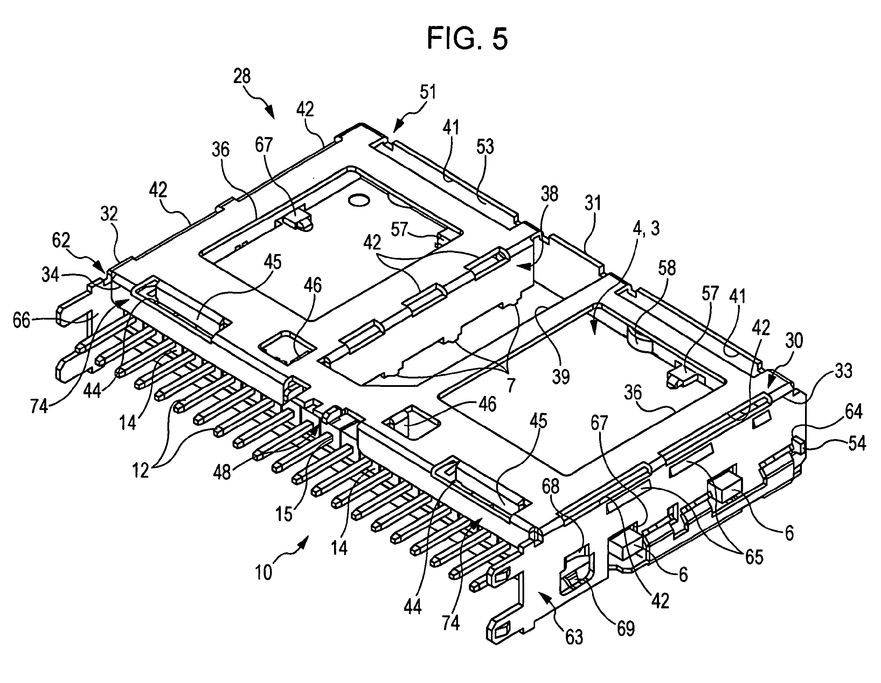

Between the front cover 78 and the back cover 88, a wiring board 3, to be described with reference to Fig. 5, is disposed that is supported by a frame 28 made of metal. The wiring board 3 is provided with an electric circuit that functions as a tuner.

In the front view of Fig. 1, in the lower portion of the wiring board 3, a group 10 of terminals are arranged in a line. The group 10 of terminals are attached to the mother board 1 without being bent. The tuner 2 is constructed upright with the front cover 78 and the back cover 88 upright. Specifically, the tuner 2 of this embodiment is about 50 mm in length, about 10 mm in width, and about 30 mm in height, and is small-sized.

The group 10 of terminals of this embodiment has a total of 21 terminals 11 (Fig. 2). For the length of the tuner 2, the number of terminals 11 is large.

The terminals 11 include input terminals, output terminals, power-supply terminals, and ground terminals. For example, a digital radio broadcast signal is input through the input terminals 11 into the electric circuit, and an output signal most suitable for the signal processing is output through the output terminals 11.

Specifically, a digital radio signal from the input terminals 11 is input through a tuned circuit and an amplifier circuit into a mixer circuit.

Into this mixer circuit, a local oscillator signal from a local oscillator is also input. The mixer circuit mixes the digital radio signal and the local oscillator signal and converts them into an intermediate frequency signal.

Next, undesired frequency components are removed from the intermediate frequency signal. After that, this damped intermediate frequency signal is amplified and detected. Thus, an audio signal most suitable for the digital radio signal processing or a video signal for a moving image can be output from the output terminals 11.

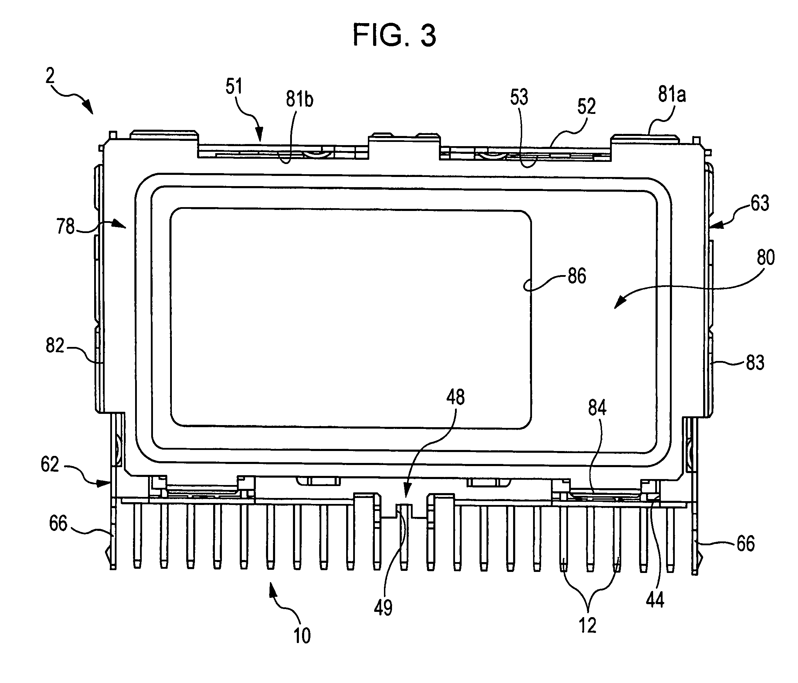

The wiring board 3 of this embodiment has a board front surface 4 that is rectangular in the front view of Fig. 3, and the electric circuit is formed on the board front surface 4.

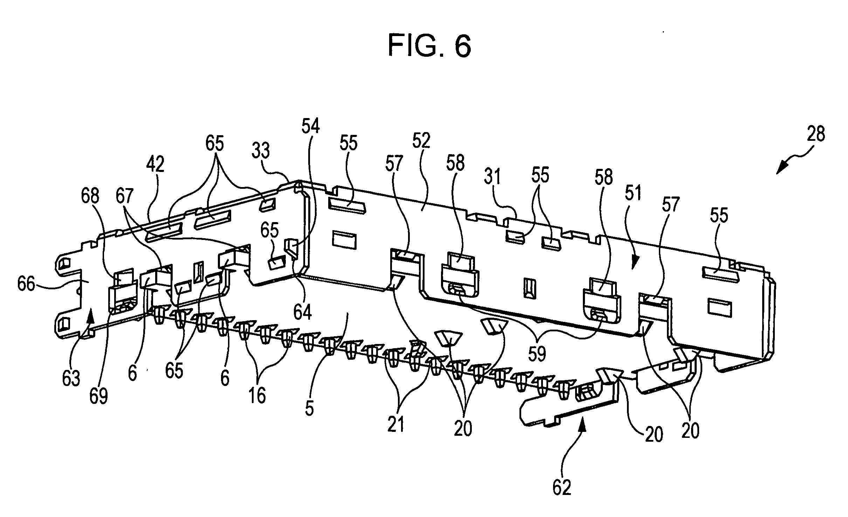

Specifically, the wiring board 3 has a board front surface 4 and a board back surface 5 facing each other in the thickness direction of the wiring board 3. The board front surface 4 can be seen in Fig. 5, and the board back surface 5 can be seen in Figs. 4 and 6. The length of the board front surface 4 and the board back surface 5 is larger than the height thereof. A wiring pattern (not shown) is provided at an appropriate position on the board front surface 4. On this wiring pattern, electronic components (not shown) are mounted.

On both left and right sides of the wiring board 3 in the front view of Fig. 3, holding arms 6, 6 that are shaped like a rectangular parallelepiped are formed (Figs. 2, 5, and 6). The holding arms 6 protrude from the edge of the wiring board 3 along the length direction thereof.

In addition, the wiring board 3 has through-holes 7 for the frame and through-holes 8 for pins bored through the board front surface 4 and the board back surface 5.

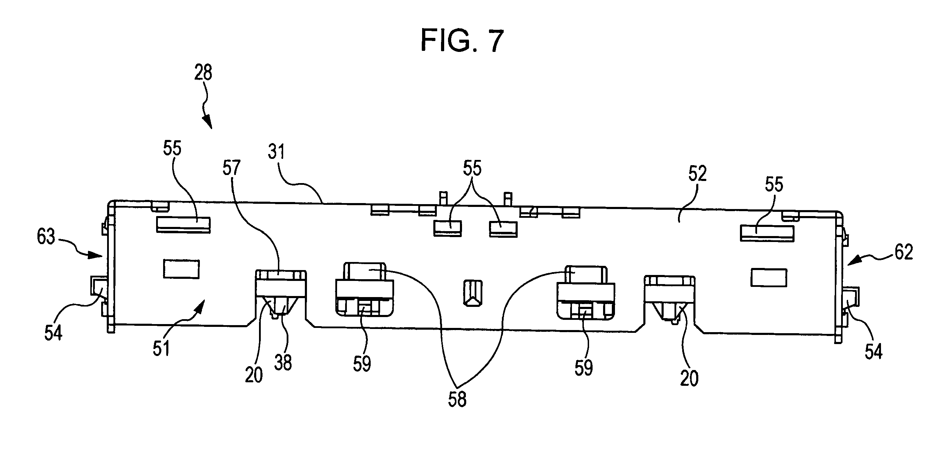

Some of the through-holes 7 for the frame can be seen in Fig. 5. In the front view of Fig. 3, the through-holes 7 for the frame are provided in the upper portion of the wiring board 3 along the length direction thereof, and on the right, left, and middle portions of the wiring board 3 along the height direction thereof. The through-holes 7 for the frame are a total of ten circular holes. The through-holes 7 for the frame can receive shield legs 38 as described below. Each shield leg 38 is fixed to the board back surface 5 with solder 20 for the frame (Figs. 6 and 7). Thus, the wiring board 3 is grounded through the frame 28.

As shown in Fig. 4, the through-holes 8 for pins are a total of 21 circular holes provided in the lower portion of the wiring board 3 in the front view of FIG. 3 along the length direction thereof. The through-holes 8 for pins can receive pins 16 that are rectangular in cross-section. The pins 16 is fixed to the board back surface 5 with solder 21 for pins.

More specifically, the terminals 11 of this embodiment include the pins 16, straight legs 12, and resin holders 14 (Figs. 5 and 6).

The straight legs 12 are rectangular in cross-section. First ends of the straight legs 12 protrude from the frame 28, are inserted into the mother board 1, and can be connected to the electrodes of the mother board 1. Second ends of the straight legs 12 are inserted into the resin holders 14.

The resin holders 14 are shaped like a rectangular parallelepiped and have square receiving holes 15 that receive the other ends of the straight legs 12.

The resin holders 14 have receiving holes (not shown) that receive the pins 16. The receiving holes for pins are perpendicular to and in communication with the receiving holes 15. Thus, the second ends of the straight legs 12 and first ends of the pins 16 are in contact with each other in the resin holders 14. When second ends of the pins 16 are inserted into the through-holes 8 for pins, the wiring pattern of the wiring board 3 and the electrodes of the mother board 1 are electrically connected to each other through the terminals 11.

The frame 28 has the functions of supporting and shielding the wiring board 3 and attaching the wiring board 3 to the mother board 1. The frame 28 includes a front plate 30, a left side plate 62, a right side plate 63, a top plate 51, and bottom plates 74.

The front plate 30 extends along the length direction and height direction of the tuner 2, is rectangular in the front view of Fig. 3, and faces the board front surface 4 (Fig. 5). The frame 28 of this embodiment is not provided with a back plate facing the board back surface 5 (Fig. 6).

Specifically, as shown in Fig. 5, the front plate 30 is defined by an upper edge 31, a left edge 32, a right edge 33, and a lower edge 34. The lower edge 34 is close to the group 10 of terminals and is located on the side opposite to the upper edge 31. The upper edge 31 and the lower edge 34 are longer than the left edge 32 and the right edge 33. In Fig. 5, the left and right ends of the upper edge 31 and the lower edge 34 intersect with the upper and lower ends of the left edge 32 and the upper and lower ends of the right edge 33.

In the middle of the front plate 30, a middle opening 39 is formed. On both left and right sides of the middle opening 39, punched portions 36, 36 are formed. The punched portions 36, 36 are openings formed by punching the front plate 30.

The middle opening 39 is an opening formed by bending shield legs 38 inward, in other words, toward the board front surface 4. On each of the borders between the middle opening 39 and the shield legs 38, three vertical openings 42 are provided along the top-bottom direction.

The vertical openings 42 facilitate the bending of the shield legs 38. The tip of the bent shield legs 38 are inserted into the through-holes 7 for the frame from the board front surface 4 so as to protrude from the board back surface 5, and are fixed to the wiring board 3 with solder 20 for the frame.

On the board back surface 5 are provided a total of ten pieces of solder 20 for the frame corresponding to the shield legs 38. In Fig. 6, of the ten pieces, two can be seen clearly in the upper portion of the wiring board 3, two in the left portion of the wiring board 3, and two in the middle of the wiring board 3.

Returning to Fig. 5 again, two vertical openings 42 are formed on each of the left edge 32 and the right edge 33, more specifically, so as to straddle each of the left edge 32 and the right edge 33. These vertical openings 42 facilitate bending the left and right side plates 62, 63 perpendicularly to the front plate 30.

On the upper edge 31, near the punched portions 36, 36, two upper openings 41 that are rectangular in the front view are formed.

The upper openings 41 facilitate bending the top plate 51 perpendicularly to the front plate 30. The upper openings 41 of this embodiment are formed by punching on the front plate 30 side of the upper edge 31, and parts of the upper edge 31 serve as the upper edges of the upper openings 41.

On the lower edge 34, near the punched portions 36, 36, two lower openings 44 that are rectangular in the front view are formed. The lower openings 44 facilitate bending the bottom plates 74 perpendicularly to the front plate 30.

The lower openings 44 are provided on the front plate 30 side of the lower edge 34, and parts of the lower edge 34 serve as the lower edges of the lower openings 44. However, unlike the upper openings 41, the lower openings 44 are not formed by punching the front plate 30.

As shown in Fig. 5, engaging pieces (engaging portions) 45 are provided on the opposite side of the lower openings 44 to the lower edge 34, and the lower openings 44 are formed by bending the engaging pieces 45 inward.

As long as the strength of the top plate 51 and the bottom plates 74 can be ensured, the upper openings 41 and the lower openings 44 may be provided so as to straddle the upper edge 31 and the lower edge 34 like the above-described vertical openings 42.

The front plate 30 has two cut and bent portions 46, 46 between the engaging pieces 45 and the middle opening 39.

The cut and bent portions 46 are bent inward like the engaging pieces 45, and hold the resin holders 14 disposed in the middle of the lower portion of the wiring board 3 against the board front surface 4. The tips of the above-described engaging pieces 45 can also hold the resin holders 14 facing them against the board front surface 4.

In addition, the front plate 30 of this embodiment has an auxiliary leg 48.

The auxiliary leg 48 extends downward from the middle portion of the lower edge 34 and is in contact with the upper surface 1a of the mother board 1 (Figs. 1 and 3). The left and right end portions of the auxiliary leg 48 protrude away from the wiring board 3, and the lower end portion of the auxiliary leg 48 has a U-shaped cross-section. This increases the area of contact with the upper surface 1a and prevents the tuner 2 from being inclined to the mother board 1.

In the middle of the lower end of the auxiliary leg 48, a recess 49 is provided (Figs. 1 and 3). The recess 49 avoids the contact with the above wiring pattern.

The right side plate 63 can be seen in Figs. 5 and 6. The right side plate 63 is contiguous with the right edge 33 of the front plate 30, is bent with respect to the front plate 30, extends along the width direction and height direction of the tuner 2, and surrounds the right portion of the wiring board 3.

At the lower end of the right side plate 63, an attaching leg 66 is provided (Fig. 6). The attaching leg 66 is inserted into the mother board 1 and used for fixing the tuner 2.

At the upper end of the right side plate 63, a receiving hole 64 is provided and used for fixing the top plate 51 to be described below.

The right side plate 63 has a total of six outer protrusions 65.

Specifically, as shown in Fig. 6, of the six outer protrusions 65, three protrude outward from the vicinity of the right edge 33 of the front plate 30, and are disposed along the right edge 33.

The other three outer protrusions 65 protrude outward from the vicinity of the opposite side from the right edge 33, and are disposed in the vicinity of the receiving hole 64 and between the holding arms 6, 6 protruding from the edge of the wiring board 3.

The right side plate 63 can support not only the holding arms 6, 6 but also the board front surface 4 and the board back surface 5.

Specifically, at the positions of the holding arms 6, 6, tongues 67, 67 are placed, and the tongues 67 are bent inward and support the board front surface 4. Between the lower holding arm 6 and the attaching leg 66, a semicircular protrusion 68 and an elastic piece 69 are provided.

The semicircular protrusion 68 protrudes inward and supports the board front surface 4. The elastic piece 69 faces the semicircular protrusion 68, is bent inward, and supports the board back surface 5.

The left side plate 62 is contiguous with the left edge 32 of the front plate 30, is bent with respect to the front plate 30, extends along the width direction and height direction of the tuner 2, and surrounds the left portion of the wiring board 3. The details of the left side plate 62 cannot be seen in Figs. 5 and 6 like the details of the right side plate 63. Like the right side plate 63, the left side plate 62 has an attaching leg 66, a receiving hole 64, outer protrusions 65, tongues 67, a semicircular protrusion 68, and an elastic piece 69.

The top plate 51 is contiguous with the upper edge 31 of the front plate 30 and is bent with respect to the front plate 30. The top plate 51 extends along the length direction and width direction of the tuner 2 and surrounds the upper portion of the wiring board 3 (Fig. 5). Specifically, the top plate 51 has a top plate lower surface 53 and a top plate upper surface 52 on the opposite side from the top plate lower surface 53 (Figs. 6 and 7). The top plate lower surface 53 is rectangular in the plan view and directly faces the upper portion of the wiring board 3. The top plate upper surface 52 has the same shape as the top plate lower surface 53. The top plate upper surface 52 is exposed to the outside.

On both left and right sides of the top plate 51, inserting arms 54 protruding along the length direction of the wiring board 3 are formed (Fig. 7). The inserting arms 54 are inserted into the receiving holes 64 of the bent left and right side plates 62 and 63. The top plate 51 bent with respect to the front plate 30 is connected not only to the front plate 30 but also to the bent left and right side plates 62 and 63.

The top plate 51 has a total of four outer protrusions 55. Specifically, the outer protrusions 55 protrude outward from the vicinity of the upper edge 31 of the front plate 30. Of the four outer protrusions 55, one is disposed in the left portion of the top plate 51, one in the right portion of the top plate 51, and two in the middle of the top plate 51.

As can easily be seen from Figs. 6 and 7, unlike the outer protrusions 65 of the left side plate 62 and the right side plate 63, the outer protrusions 55 are not disposed on the opposite side from the upper edge 31.

The top plate 51 can also support the board front surface 4 and the board back surface 5. Tongues 57, 57 are bent inward and support the board front surface 4 (Fig. 6). Between the tongues 57, 57, two sets of a semicircular protrusion 58 and an elastic pieces 59 are provided. The semicircular protrusions 58 protrude inward and support the board front surface 4. The elastic pieces 59 face the semicircular protrusions 58, are bent inward, and support the board back surface 5.

As shown in Fig. 5, the bottom plates 74 are located below the engaging pieces 45 of the front plate 30, are contiguous with the lower edge 34 of the front plate 30, are bent with respect to the front plate 30, extend along the length direction and width direction of the tuner 2 like the top plate 51, and surround the lower portion of the wiring board 3.

However, the bottom plates 74 are not connected to the left side plate 62 and the right side plate 63 like the top plate 51, and are connected only to the front plate 30. The bottom plates 74 are disposed on both left and right sides of the auxiliary leg 48 and have a width that does not reach the peripheral surfaces of the straight legs 12.

Together with the frame 28, the front cover 78 and the back cover 88 function to shield the wiring board 3.

The front cover 78 has a front lid 80 (Fig. 3). The front lid 80 extends along the length direction and height direction of the tuner 2 and covers the frame 28. The front lid 80 is rectangular in the front view of Fig. 3, faces the front plate 30, and covers the whole thereof.

As shown in Fig. 3, the front lid 80 has an inward depressed central depression 86, to which a label (not shown) concerning the tuner 2 is applied. If a label is applied to a position lower than the front lid 80, the label can be prevented from peeling or grazing due to the contact with the adjacent tuner 2 when the tuner 2 is packed and transported.

In the front view of Fig. 3, the front lid 80 engages with the frame 28 in the top-bottom direction and left-right direction thereof.

Specifically, as shown in Figs. 3, 8, and 9, on the upper side of the front lid 80, three upper holding arms (first upper arms) 81a and two lower supporting arms (second upper arms) 81b are provided.

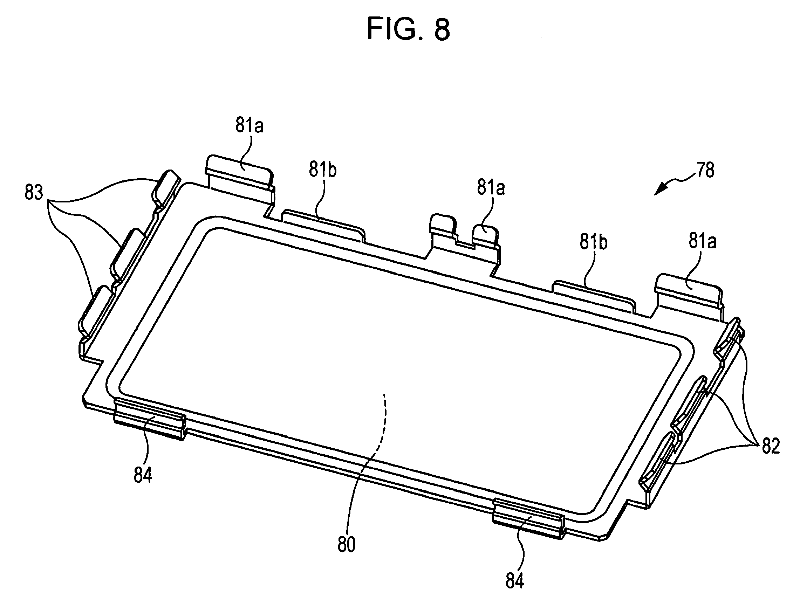

In Fig. 8, the back surface of the front cover 78 directly facing the front plate 30 can be seen, and the front lid 80 of Fig. 3 cannot be seen.

The upper holding arms 81a are disposed at both left and right ends and in the middle of the top of the front lid 80, and can engage with the outer protrusions 55 on the top plate upper surface 52. Specifically, the upper holding arms 81a are bent perpendicularly to the front lid 80, have a hook shape that engages with the outer protrusions 55, and hold the top plate upper surface 52 from above.

The lower supporting arms 81b are disposed on both left and right sides of the middle one of the three upper holding arms 81a. Like the upper holding arms 81a, the lower supporting arms 81b are bent perpendicularly to the front lid 80. However, unlike the upper holding arms 81a, the lower supporting arms 81b are flat. The lower supporting arms 81b are inserted into the upper openings 41 of the front plate 30 and support the top plate lower surface 53 from below. That is, the upper holding arms 81a and the lower supporting arms 81b form a clip structure that pinches the top plate 51.

Three left holding arms 82 are provided on the left side (corresponding to the right side in Fig. 8) of the front lid 80, and three right holding arms 83 are provided on the right side (corresponding to the left side in Fig. 8) of the front lid 80.

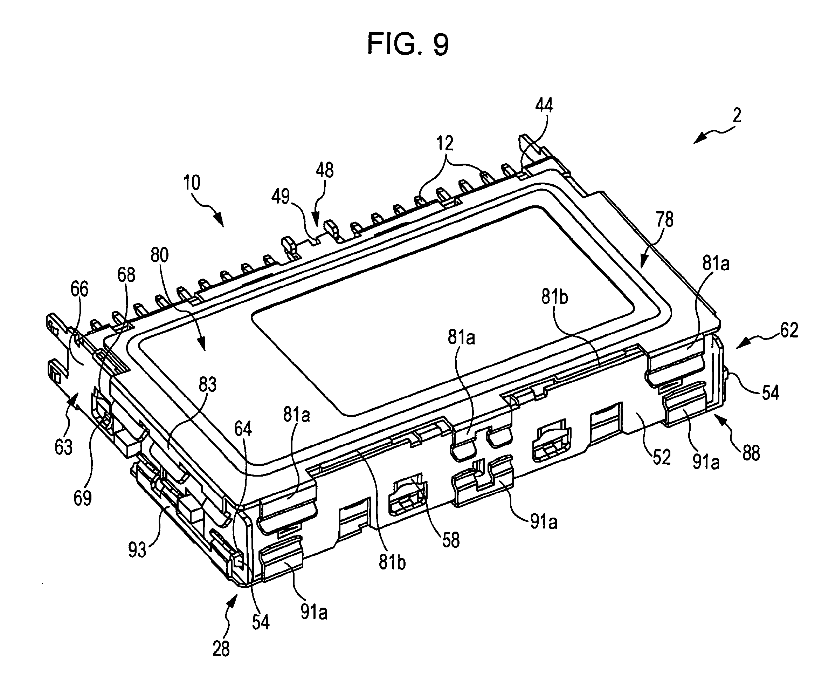

The left holding arms 82 and the right holding arms 83 are bent perpendicularly to the front lid 80, have a hook shape engaging with the outer protrusions 65, and hold the left side plate 62 and the right side plate 63 from the side (Fig. 9).

On the lower side of the front lid 80, two holding arms 84 are provided (Figs. 2 and 8). The holding arms 84 are disposed at positions corresponding to the lower openings 44, and are bent perpendicularly to the front lid 80. Because the holding arms 84 are inserted into the lower openings 44, the holding arms 84 have a hook shape that supports not the bottom plates 74 but the engaging pieces 45 from below.

As shown in Fig. 4, the back cover 88 has a back lid 90. The back lid 90 extends along the length direction and height direction of the tuner 2, faces the board back surface 5, and covers the whole of the board back surface 5. The back cover 88 has such a structure that the holding arms 84 are omitted from the front cover 78 shown in Fig. 8. The reason is that the frame 28 of this embodiment does not have a back plate.

That is, the back cover 88 of this embodiment has three upper holding arms 91a and two lower supporting arms 91b on the upper side of the back lid 90, and the upper holding arms 91a and the lower supporting arms 91b are bent perpendicularly to the back lid 90 (Fig. 4).

The upper holding arms 91a hold the top plate upper surface 52 from above, and the lower supporting arms 91b support the top plate lower surface 53 from below (Figs. 4 and 9). The upper holding arms 91a and the lower supporting arms 91b form a clip structure that pinches the top plate 51.

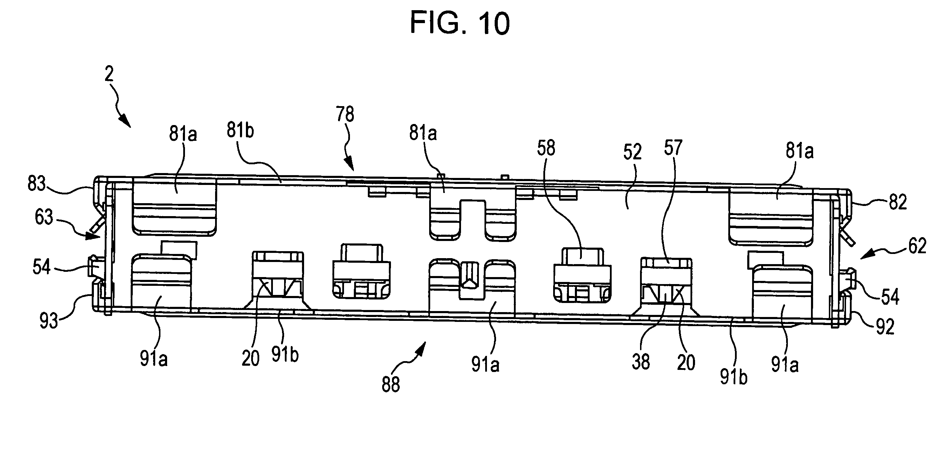

Although the upper holding arms 91a have a hook shape, the upper holding arms 91a just hold the top plate upper surface 52 from above (Figs. 7 and 10). The reason is that as described above, the back cover 88 does not have holding arms 84 like the front cover 78, and in order to balance the engaging force in the top-bottom direction of the back cover 88, outer protrusions engaging with the back cover 88 are not provided on the top plate upper surface 52 (Figs. 6 and 7).

Because the frame 28 does not have a back plate, the lower supporting arms 91b are not inserted into the upper openings 41 like the lower supporting arms 81b.

Therefore, there is fear that the clip structure of the upper holding arms 91a and the lower supporting arms 91b is inferior to the clip structure of the upper holding arms 81a and the lower supporting arms 81b in holding force.

However, on the left and right sides of the back lid 90, left holding arms 82 and right holding arms 83 engaging with the outer protrusions 65 in Fig. 6 are provided, and the left holding arms 82 and the right holding arms 83 hold the left side plate 62 and the right side plate 63 from the side (Figs. 9, 10, and 11), and therefore the back cover 88 does not come off of the frame 28, either.

How a tuner 2 having the above-described structure is constructed will be described. First, a wiring board 3 on the board front surface 4 of which an electric circuit is provided is prepared.

The wiring board 3 is placed with the board back surface 5 up, and solder 21 for pins is applied around each through-hole 8 for pins. Specifically, the solder 21 for pins is applied away from the edge of each through-hole 8 for pins, for example, in front of and behind each through-hole 8 for pins in Fig. 4. The purpose is to prevent the solder 21 for pins from adhering to the pins 16 when the pins 16 protrude from the board back surface 5.

Next, the wiring board 3 is turned over so that the board front surface 4 is up, and terminals 11 are attached to the wiring board 3. Specifically, resin holders 14 having straight legs 12 and pins 16 are prepared. The straight legs 12 are caused to protrude from the lower portion of the wiring board 3. The pins 16 are inserted into the through-holes 8 for pins from the board front surface 4 so as to protrude from the board back surface 5.

The through-holes 8 for pins differ slightly in diameter in the length direction of the tuner 2. The pins 16 are lightly press-fitted into the through-holes 8 for pins located both left and right ends of the wiring board 3, and are inserted in a free state into the through-holes 8 for pins located in the middle of the wiring board 3.

Next, a frame 28 with the top plate 51, the left side plate 62, the right side plate 63, and the bottom plates 74 bent with respect to the front plate 30 is prepared.

The wiring board 3 placed with the board front surface 4 up is held with the frame 28, the board front surface 4 is covered with the front plate 30, and the holding arms 6 are held with the left side plate 62 and the right side plate 63. Thus, the wiring board 3 is surrounded by the top plate 51, the left side plate 62, the right side plate 63, and the bottom plates 74 (Fig. 5).

At that time, the elastic pieces 59 of the top plate 51 and the elastic pieces 69 of the left side plate 62 and right side plate 63 are bent inward and brought into contact with the board back surface 5 (Fig. 6).

The elastic pieces 59, 69 come into contact with the board back surface 5 and bend, and the semicircular protrusions 58 of the top plate 51 and the semicircular protrusions 68 of the left side plate 62 and the right side plate 63 support the board front surface 4 at positions facing the elastic pieces 59, 69.

Therefore, the wiring board 3 is held at the proper position by the elastic pieces 59 and the semicircular protrusions 58, and by the elastic pieces 69 and the semicircular protrusions 68.

The board front surface 4 is supported also by the tongues 57, 67 bent inward.

In addition, the cut and bent portions 46 hold the resin holders 14 against the board front surface 4. Therefore, even if the diameter of the through-holes 8 for pins decreases during the reflow process, the resin holders 14, particularly the resin holders 14 having pins 16 inserted in a free state into the through-holes 8 for pins are kept in place.

The tips of the shield legs 38 are inserted into the through-holes 7 for the frame from the board front surface 4 so as to protrude from the board back surface 5. Solder 20 for the frame is applied to the tips of the shield legs 38 protruding from the board back surface 5. After that, the frame 28 is reflow-connected to the wiring board 3 with the solder 20 for the frame, and at the same time, the group 10 of terminals are reflow-connected to the wiring board 3 with the solder 21 for pins.

Next, the front cover 78 and the back cover 88 are attached to the frame 28 in Fig. 5.

The front cover 78 covers the front plate 30 with the front lid 80. The upper holding arms 81a hold the top plate upper surface 52, engage with the outer protrusions 55, and are fixed to the top plate upper surface 52. At the same time, the lower supporting arms 81b are inserted into the upper openings 41 and support the top plate lower surface 53 (Figs. 2, 9, and 10).

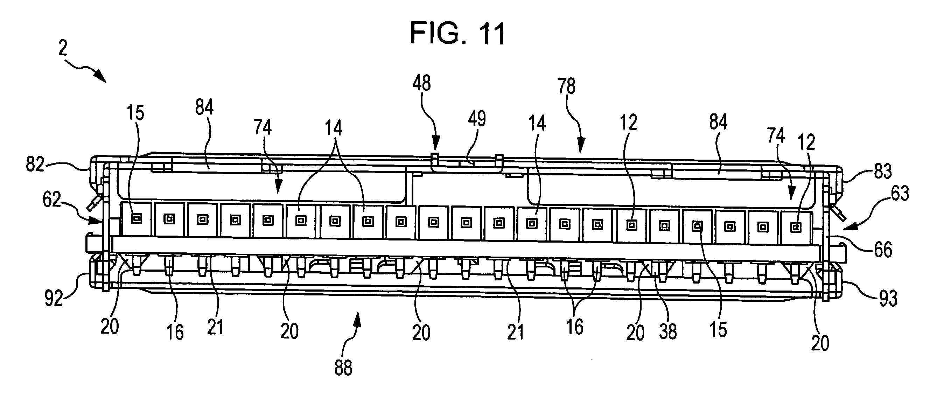

The left holding arms 82 and the right holding arms 83 engage with the outer protrusions 65 and are fixed to the left side plate 62 and the right side plate 63 (Figs. 9 to 11). The holding arms 84 are inserted into the lower openings 44 and support the engaging pieces 45 (Figs. 2 and 11).

The back cover 88 covers the board back surface 5 with the back lid 90. The upper holding arms 91a hold the top plate upper surface 52, and the lower supporting arms 91b support the top plate lower surface 53 (Fig. 10).

The left holding arms 92 and the right holding arms 93 engage with the outer protrusions 65 and are fixed to the left side plate 62 and the right side plate 63 (Figs. 9 to 11).

More specifically, the upper holding arms 81a and the outer protrusions 55 are swaged together, the left holding arms 82, the right holding arms 83, and the outer protrusions 65 are swaged together, and the position of the front cover 78 relative to the frame 28 is determined. Similarly, the left holding arms 92, the right holding arms 93, and the outer protrusions 65 are swaged together, and the position of the back cover 88 relative to the frame 28 is determined.

After that, as shown in Fig. 1, the attaching legs 66 of the frame 28 and the straight legs 12 of the terminals 11 are inserted into the upper surface 1a of the mother board 1 so as to protrude from the lower surface 1b.

When the auxiliary leg 48 of the frame 28 comes into contact with the upper surface 1a, the attachment of the tuner 2 to the mother board 1 is completed.

As described above, according to this embodiment, the tuner 2 includes a wiring board 3, a group 10 of terminals, a frame 28, a front cover 78, and a back cover 88 and is constructed not in a prone position but in an upright position. Specifically, when the direction in which the group 10 of terminals are arranged, in other words, the left-right direction of the frame 28 is referred to as length direction, the thickness direction of the wiring board 3 is referred to as width direction, and the top-bottom direction of the frame 28 is referred to as height direction, the tuner 2 is constructed such that the size in the height direction of the tuner 2 is larger than the size in the width direction of the tuner 2.

The wiring board 3 is supported by the frame 28 made of metal. The frame 28 is covered by the front cover 78 and the back cover 88 made of metal. Thus, the inside of the tuner 2 can be shielded from the outside.

The bottom plates 74 of the frame 28 avoid the group 10 of terminals extending toward the mother board 1. The group 10 of terminals can be placed densely along the length direction of the tuner 2. Thus, the size in the length direction of the tuner 2 can be reduced.

In the case where the bottom plates 74 are not connected to the left side plate 62 and the right side plate 63 and are contiguous only with the lower edge 34 of the front plate 30, there is fear that the bottom plate 74 could be deformed. Specifically, for example, if the front cover 78 holds the top plate upper surface 52 from above, supports the lower surfaces of the bottom plates 74 from below, and covers the frame 28, the bottom plates 74 contiguous only with the lower edge 34 of the front plate 30 are prone to be bent inward from their proper positions.

However, according to this embodiment, the front plate 30 of the frame 28 is provided with lower openings 44 and engaging pieces 45, and the holding arms 84 of the front cover 78 support the engaging pieces 45 which are separate from the bottom plates 74.

If the front cover 78 does not support the lower surfaces of the bottom plates 74 from below but supports the lower surfaces of the engaging pieces 45 provided in the front plate 30 from below when the front cover 78 covers the frame 28 in the top-bottom direction of the front cover 78, the bottom plates 74 can maintain their proper positions, and the decrease in shielding performance can be prevented.

In addition, the misalignment of the front cover 78 with respect to the frame 28 is avoided, and the frame 28 and the front cover 78 are in contact with each other at their proper contact position, and therefore noise generation can be prevented. As a result, the reliability of the tuner 2 improves.

If the lower openings 44 are formed on the borders between the front plate 30 and the bottom plates 74, the bottom plates 74 can be bent to their proper positions easily.

In addition, because the lower openings 44 also have a function to provide engaging pieces 45, the need to separately form the openings for facilitating bending and the openings for providing the engaging pieces is eliminated, and the decrease in shielding performance can be further prevented.

The front cover 78 covers the top plate 51 of the frame 28 with a clip structure. Specifically, upper holding arms 81a hold the top plate upper surface 52 from above, and lower supporting arms 81b support the top plate lower surface 53 from below. The top plate 51 is pinched between the upper holding arms 81a and the lower supporting arms 81b. Therefore, the front cover 78 is less prone to come off of the frame 28.

If upper openings 41 are formed on the border between the front plate 30 and the top plate 51, the top plate 51 can be bent easily.

In addition, because the upper openings 41 also has a function to receive the lower supporting arms 81b, the need to separately form the openings for facilitating bending and the openings for inserting the lower supporting arms is eliminated, and the decrease in shielding performance can be further prevented.

If the upper holding arms 81a engage with outer protrusions 55, the position of the front cover 78 relative to the frame 28 is defined, and the frame 28 and the front cover 78 can be in contact with each other at their original contact position more firmly.

The back cover 88 also covers the top plate 51 of the frame 28 with a clip structure. Specifically, upper holding arms 91a hold the top plate upper surface 52 from above, and lower supporting arms 91b support the top plate lower surface 53 from below. The top plate 51 is pinched between the upper holding arms 91a and the lower supporting arms 91b.

If the left and right holding arms 92 and 93 engage with the outer protrusions 65 of the left and right side plates 62 and 63, the position of the back cover 88 relative to the frame 28 is defined, and the frame 28 and the back cover 88 can be in contact with each other at their proper contact position firmly. Therefore, the back cover 88 is also less prone to come off of the frame 28.

When attaching the frame 28 to the wiring board 3, the wiring board 3 can be temporarily attached to the frame 28 easily by receiving the board back surface 5 with the elastic pieces 59, 69 and then pinching the wiring board 3 between the elastic pieces 59, 69 and the semicircular protrusions 58, 68.

If an auxiliary leg 48 is provided between the attaching legs 66 of the left and right side plates 62, 63, the inclination of the tuner 2 to the mother board 1 can be prevented, and contact failure between the group 10 of terminals and the electrodes of the mother board 1 can be avoided. Because the auxiliary leg 48 increases the area of contact with the upper surface 1a of the mother board 1 by its U-shaped contact surface, the position of the tuner 2 is further stabilized.

The present invention is not limited to the above embodiment, and various changes may be made therein without departing from the claims.

In the above embodiment, a description is given of a structure in which the upper openings 41 and the lower openings 44 are provided at positions where the openings can be used for facilitating the bending of the top plate 51 and the bottom plates 74, a clip structure of the front cover 78 that pinches the top plate 51, a structure in which the engaging force between the frame 28 and the front cover 78 is obtained using the outer protrusions 55, 65, and so forth.

However, the above embodiment is an optimum example. The present invention does not necessarily have to have all the structures. Some of the components of the above embodiment can be omitted. The components of the above embodiment can be combined in different ways.

In the above embodiment, the present invention is embodied as an FM/AM tuner 2. Of course the present invention can also be applied to a small television tuner as long as it is attached upright to the mother board 1.

In any of these cases, the size of the electronic device can be reduced, and the decrease in shielding performance and the generation of noise can be prevented.

## Claims

1. An electronic device (2) attached upright to a set board (1), the device comprising:
a wiring board (3) having a board surface (4) that is rectangular in the front view and on which a wiring pattern and electronic components are provided;
a group (10) of terminals arranged in a line in the lower portion of the wiring board and connecting the wiring board and the set board;
a metal frame (28) supporting the wiring board and used for the attachment to the set board; and
a metal lid (78) covering the frame,
the frame including:
a front plate (30) facing the board surface (4) and having a lower opening (44) formed in the lower portion thereof and an engaging portion (45) cut and bent inward when the lower opening is formed;
a left side plate (62) and a right side plate (63) contiguous with the left edge (32) and the right edge (33) of the front plate and surrounding the left portion and the right portion of the wiring board;
a top plate (51) contiguous with the upper edge (31) of the front plate and having a top plate upper surface (52) connected to the left side plate and the right side plate and surrounding the upper portion of the wiring board; and
a bottom plate (74) that is located on the opposite side from the top plate with the engaging portion therebetween, that is contiguous with the lower edge (34) of the front plate, that is not connected to the left side plate and the right side plate, that avoids the group of terminals, and that surrounds the lower portion of the wiring board,
the lid including:
a front lid (80) covering the front plate;
a first upper arm (81a) contiguous with the front lid and holding the top plate upper surface from above; and
a holding arm (84) contiguous with the front lid, inserted into the lower opening, and supporting the engaging portion from below.

2. The electronic device according to Claim 1, wherein the lower opening is formed on the lower edge of the front plate.

3. The electronic device according to Claim 1 or 2, wherein the front plate has an upper opening (41) in the upper portion thereof, and the lid has a second upper arm (81b) that is inserted into the upper opening and supports a top plate lower surface (53) facing the edge of the wiring board from below.

4. The electronic device according to Claim 3, wherein the upper opening is formed on the upper edge of the front plate.

5. The electronic device according to any one of Claims 1 to 4, wherein the top plate upper surface has an outer protrusion (55) protruding outward in the vicinity of the upper edge of the front plate, and the first upper arm engages with the outer protrusion and holds the top plate upper surface from above.

## Patentansprüche

1. Elektronische Vorrichtung (2), die aufrecht an einer Bestückungsplatte (1) angebracht ist, wobei die Vorrichtung Folgendes aufweist:
eine Verdrahtungsplatte (3) mit einer Plattenoberfläche (4), die in Frontansicht rechteckig ausgebildet ist und auf der ein Verdrahtungsmuster und elektronische Bauelemente vorgesehen sind;
eine Gruppe (10) von Anschlüssen, die in einer Reihe in dem unteren Bereich der Verdrahtungsplatte angeordnet sind und die Verdrahtungsplatte und die Bestückungsplatte miteinander verbinden;
einen Metallrahmen (28), der die Verdrahtungsplatte abstützt und zur Anbringung an der Bestückungsplatte verwendet wird; und
eine Metallabdeckung (78), die den Rahmen bedeckt, wobei der Rahmen Folgendes aufweist:
eine der Plattenoberfläche (4) zugewandte vordere Platte (30) mit einer in dem unteren Bereich derselben ausgebildeten unteren Öffnung (44) und einem Eingriffsbereich (45), der beim Bilden der unteren Öffnung geschnitten und nach innen umgebogen wird;
eine linke Seitenplatte (62) und eine rechte Seitenplatte (63), die an den linken Rand (32) und den rechten Rand (33) der vorderen Platte anschließen sowie den linken Bereich und den rechten Bereich der Verdrahtungsplatte umschließen;
eine obere Platte (51), die an den oberen Rand (31) der vorderen Platte anschließt und eine obere Oberfläche (52) der oberen Platte aufweist und die mit der linken Seitenplatte und der rechten Seitenplatte verbunden ist und den oberen Bereich der Verdrahtungsplatte umschließt; und
eine untere Platte (74), die auf der gegenüberliegenden Seite von der oberen Platte unter Zwischenanordnung des Eingriffsbereichs angeordnet ist, die an den unteren Rand (34) der vorderen Platte anschließt und die nicht mit der linken Seitenplatte und der rechten Seitenplatte verbunden ist, die die Gruppe von Anschlüssen umgeht und die den unteren Bereich der Verdrahtungsplatte umschließt,
wobei die Abdeckung aufweist:
eine vordere Abdeckung (80), die die vordere Platte bedeckt;
einen ersten oberen Arm (81a), der an die vordere Abdeckung anschließend ausgebildet ist und die obere Oberfläche der oberen Platte von oben hält; und
einen Haltearm (84), der an die vordere Abdeckung anschließend ausgebildet ist, in die untere Öffnung eingesetzt ist und den Eingriffsbereich von unten abstützt.

2. Elektronische Vorrichtung nach Anspruch 1,
wobei die untere Öffnung an dem unteren Rand der vorderen Platte gebildet ist.

3. Elektronische Vorrichtung nach Anspruch 1 oder 2,
wobei die vordere Platte eine obere Öffnung (41) in ihrem oberen Bereich aufweist und die Abdeckung einen zweiten oberen Arm (81b) aufweist, der in die obere Öffnung eingesetzt ist und eine dem Rand der Verdrahtungsplatte zugewandte untere Oberfläche (53) der oberen Platte von unten abstützt.

4. Elektronische Vorrichtung nach Anspruch 3,
wobei die obere Öffnung an dem oberen Rand der vorderen Platte gebildet ist.

5. Elektronische Vorrichtung nach einem der Ansprüche 1 bis 4,
wobei die obere Oberfläche der oberen Platte einen nach außen vorstehenden äußeren Vorsprung (55) in der Nähe des oberen Rands der vorderen Platte aufweist und der erste obere Arm mit dem äußeren Vorsprung in Eingriff tritt und die obere Oberfläche der oberen Platte von oben hält.

## Revendications

1. Dispositif électronique (2) fixé perpendiculairement à une carte de montage (1), le dispositif comprenant :
une carte de câblage (3) ayant une surface de carte (4) rectangulaire vue de face et sur laquelle sont disposés un motif de câblage et des composants électroniques ;
un groupe (10) de bornes agencées en ligne dans la partie inférieure de la carte de câblage et reliant la carte de câblage et la carte de montage ;
un châssis métallique (28) supportant la carte de câblage et utilisé pour la fixation à la carte de montage ; et
un couvercle métallique (78) recouvrant le châssis,
le châssis incluant :
une plaque avant (30) tournée vers la surface de la carte (4) et ayant une ouverture inférieure (44) formée dans sa partie inférieure et une partie d'engagement (45) coupée et pliée vers l'intérieur lorsque l'ouverture inférieure est formée ;
une plaque latérale gauche (62) et une plaque latérale droite (63) contiguës avec le bord gauche (32) et le bord droit (33) de la plaque avant et entourant la partie gauche et la partie droite de la carte de câblage ;
une plaque supérieure (51) contiguë avec le bord supérieur (31) de la plaque avant et ayant une surface supérieure de plaque supérieure (52) reliées à la plaque latérale gauche et à la plaque latérale droite et entourant la partie supérieure de la carte de câblage ; et
une plaque inférieure (74) située sur la face opposée par rapport à la plaque supérieure, avec la partie d'engagement entre elles, contiguë avec le bord inférieur (34) de la plaque avant, qui n'est pas reliée à la plaque latérale gauche et à la plaque latérale droite, évitant le groupe de bornes et entourant la partie inférieure de la carte de câblage,
le couvercle incluant :
un couvercle avant (80) recouvrant la plaque avant ;
un premier bras supérieur (81a) contigu avec le couvercle avant et maintenant la surface supérieure de la plaque supérieure à partir du dessus ; et
un bras support (84) contigu avec le couvercle avant, inséré dans l'ouverture inférieure et supportant la partie d'engagement à partir du dessous.

2. Dispositif électronique selon la revendication 1, dans lequel l'ouverture inférieure est formée sur le bord inférieur de la plaque avant.

3. Dispositif électronique selon la revendication 1 ou 2, dans lequel la plaque avant comporte une ouverture supérieure (41) dans sa partie supérieure et le couvercle comporte un deuxième bras supérieur (81b) inséré dans l'ouverture supérieure et supportant une surface inférieure de plaque supérieure (53) tournée vers le bord de la carte de câblage à partir du dessous.

4. Dispositif électronique selon la revendication 3, dans lequel l'ouverture supérieure est formée sur le bord supérieur de la plaque avant.

5. Dispositif électronique selon l'une quelconque des revendications 1 à 4, dans lequel la surface supérieure de la plaque supérieure comporte une protubérance extérieure (55) faisant saillie vers l'extérieur au voisinage du bord supérieur de la plaque avant et le premier bras supérieur s'engage avec la protubérance extérieure et maintient la surface supérieure de la plaque supérieure à partir du dessus.
